(19)

Europäisches Patentamt

European Patent Office

Office européen des brevets

(11) **EP 4 016 764 A1**

(12) **EUROPEAN PATENT APPLICATION**

(43) Date of publication:
**22.06.2022 Bulletin 2022/25**

(21) Application number: **21214401.8**

(22) Date of filing: **14.12.2021**

(51) International Patent Classification (IPC):
*H01S 5/20* *(2006.01)*     *H01S 5/14* *(2006.01)*
*H01S 5/32* *(2006.01)*     *H01S 5/50* *(2006.01)*
*H01S 5/02* *(2006.01)*     *H01S 5/028* *(2006.01)*
*H01S 5/10* *(2021.01)*     *H01S 5/30* *(2006.01)*
*H01S 5/34* *(2006.01)*     *H01S 5/343* *(2006.01)*

(52) Cooperative Patent Classification (CPC):
**H01S 5/50; H01S 5/142; H01S 5/2031;**
**H01S 5/3213;** H01S 5/021; H01S 5/0239;
H01S 5/0287; H01S 5/101; H01S 5/1085;
H01S 5/305; H01S 5/3054; H01S 5/3086;
H01S 5/309; H01S 5/3415; H01S 5/34306

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.12.2020 US 202017122583**

(71) Applicant: **Marvell Asia Pte, Ltd.**
**Singapore 369522 (SG)**

(72) Inventors:
• **He, Xiaoguang**
**San Jose, CA (US)**
• **Nagarajan, Radhakrishnan L.**
**San Jose, CA (US)**

(74) Representative: **Grünecker Patent- und**
**Rechtsanwälte**
**PartG mbB**
**Leopoldstraße 4**
**80802 München (DE)**

(54) **GAIN MEDIUM STRUCTURE FOR SEMICONDUCTOR OPTICAL AMPLIFIER WITH HIGH SATURATION POWER**

(57)     A gain medium for semiconductor optical amplifier in high-power operation includes a substrate with n-type doping; a lower clad layer formed overlying the substrate; a lower optical confinement stack overlying the lower clad layer; an active layer comprising a multi-quantum-well heterostructure with multiple well layers characterized by about 0.8% to 1.2% compressive strain respectively separated by multiple barrier layers characterized by about -0.1% to -0.5% tensile strain. The active layer overlays the lower optical confinement stack. The gain medium further includes an upper optical confinement stack overlying the active layer, the upper optical confinement stack being set thinner than the lower optical confinement stack; an upper clad layer overlying the upper optical confinement stack; and a p-type contact layer overlying the upper clad layer.

FIG. 1

EP 4 016 764 A1

**Description**

BACKGROUND OF THE INVENTION

The present invention relates to optical communication techniques. More particularly, the present invention provides a gain medium structure for semiconductor optical amplifier for high-power elevated temperature operation.

Over the last few decades, the use of communication networks exploded. In the early days Internet, popular applications were limited to emails, bulletin board, and mostly informational and text-based web page surfing, and the amount of data transferred was usually relatively small. Today, Internet and mobile applications demand a huge amount of bandwidth for transferring photo, video, music, and other multimedia files. For example, a social network like Facebook processes more than 500TB of data daily. With such high demands on data and data transfer, existing data communication systems need to be improved to address these needs.

40-Gbit/s and then 100-Gbit/s data rates wide-band DWDM (Dense Wavelength Division Multiplexed) optical transmission over existing single-mode fiber is a target for the next generation of fiber-optic communication networks. More recently, optical components are being integrated on silicon substrates for fabricating large-scale photonic integrated circuits that coexist with micro-electronic chips. a whole range of photonic components, including filters, (de)multiplexers, splitters, modulators, and photodetectors, have been demonstrated, mostly in the silicon-photonics platform. The silicon-photonics platform on silicon-on-insulator substrate is especially suited for standard WDM communication bands at 1300 nm and 1550 nm, as silicon (n = 3.48) and its oxide $SiO_2$ (n = 1.44) are both transparent, and form high-index contrast, high-confinement waveguides ideally suited for medium to high-integration silicon photonics integrated circuits (SPICs).

Semiconductor optical amplifier in silicon photonics platform have been implemented for many applications of optical communication. For example, wavelength tunable lasers based on the semiconductor optical amplifier (SOA) and reflective semiconductor optical amplifier (RSOA) are provided as key elements in SPICs for wide-band optical communication with increasing spectral efficiency. However, technical challenges exist for developing gain chip for high-power SOA/RSOA for operation at elevated temperature in wide-band high-speed data communication application. Therefore, improved techniques are desired.

BRIEF SUMMARY OF THE INVENTION

The present invention relates to optical telecommunication techniques. One aspect of the present invention provides a gain medium structure for a semiconductor optical amplifier (SOA) and/or a reflective semiconductor optical amplifier (RSOA) for tunable lasers in high-power elevated temperature application. More particularly, the present invention provides a gain medium having wider n side separated confinement heterostructure, narrower quantum well, and optimized active layer confinement factor used in SOA/RSOA with high saturation power at elevated temperature for a wide-band wavelength tunable laser in high-speed data communication application, though other applications are possible.

In an embodiment, the present invention provides a gain medium for semiconductor optical amplifier in high-power operation. The gain medium includes a substrate with n-type doping and a lower clad layer formed overlying the substrate. The gain medium further includes a lower optical confinement stack overlying the lower clad layer. Additionally, the gain medium includes an active layer comprising a multi-quantum-well heterostructure with multiple well layers characterized by about 0.8% to 1.2% compressive strain respectively separated by multiple barrier layers characterized by about -0.1% to -0.5% tensile strain. The active layer overlays the lower optical confinement stack. The gain medium further includes an upper optical confinement stack overlying the active layer, the upper optical confinement stack being set thinner than the lower optical confinement stack. Furthermore, the gain medium includes an upper clad layer overlying the upper optical confinement stack. Moreover, the gain medium includes a p-type contact layer overlying the upper clad layer.

In an alternative embodiment, the present invention provides a method of forming a gain medium for semiconductor optical amplifier in high-power operation. The method includes a step of providing a substrate with n-type doping. The method further includes a step of forming lower clad layer formed overlying the substrate. Additionally, the method includes a step of forming a lower optical confinement stack overlying the lower clad layer. The method further includes a step of forming an active layer comprising a multi-quantum-well heterostructure with multiple well layers characterized by about 0.8% to 1.2% compressive strain respectively separated by multiple barrier layers characterized by about -0.1% to -0.5% tensile strain. The active layer is configured to overlay the lower optical confinement stack. Furthermore, the method includes a step of forming an upper optical confinement stack overlying the active layer, the upper optical confinement stack being set thinner than the lower optical confinement stack. The method further includes a step of forming an upper clad layer overlying the upper optical confinement stack. Moreover, the method includes a step of forming a p-type contact layer overlying the upper clad layer. In the embodiment, the lower optical confinement stack is made with a larger thickness than the upper optical confinement stack. In the embodiment, the active layer is configured with an optimized confinement factor ratio of 1.27+/- 0.15 (1/$\mu$m) and a gain parameter of 15+/-5 (1/cm) for providing the gain medium in use of an 1 mm long cavity device.

The present invention achieves these benefits and others in the context of known technology of semiconductor optical amplifier for tunable laser. However, a further understanding of the nature and advantages of the present invention may be realized by reference to the latter portions of the specification and attached drawings.

BRIEF DESCRIPTION OF THE DRAWINGS

The following diagrams are merely examples, which should not unduly limit the scope of the claims herein. One of ordinary skill in the art would recognize many other variations, modifications, and alternatives. It is also understood that the examples and embodiments described herein are for illustrative purposes only and that various modifications or changes in light thereof will be suggested to persons skilled in the art and are to be included within the spirit and purview of this process and scope of the appended claims.

Figure 1 is a schematic diagram of a RSOA with a gain medium in both top and side views according to an embodiment of the present invention.

Figure 2 is a schematic diagram of a SOA with a gain medium in both top and side views according to an embodiment of the present invention.

Figure 3 is a simplified bandgap diagram of a gain medium of RSOA/SOA for tunable laser application according to an embodiment of the present invention.

Figure 4 is a schematic diagram of a tunable laser based on a reflective semiconductor optical amplifier (RSOA) combined with a semiconductor optical amplifier (SOA) according to an embodiment of the present invention.

DETAILED DESCRIPTION OF THE INVENTION

The present invention relates to optical telecommunication techniques. One aspect of the present invention provides a gain medium structure for a semiconductor optical amplifier (SOA) and/or a reflective semiconductor optical amplifier (RSOA) for tunable lasers in high-power elevated temperature application. More particularly, the present invention provides a gain medium having wider n side separated confinement heterostructure, narrower quantum well, and optimized active layer confinement factor used in SOA/RSOA with high saturation power at elevated temperature for a wide-band wavelength tunable laser in high-speed data communication application, though other applications are possible.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

In the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

Please note, if used, the labels inner, outer, left, right, front, back, top, bottom, end, forward, reverse, clockwise and counterclockwise have been used for convenience purposes only and are not intended to imply any particular fixed direction. Instead, they are used to reflect relative locations and/or directions between various portions of an object.

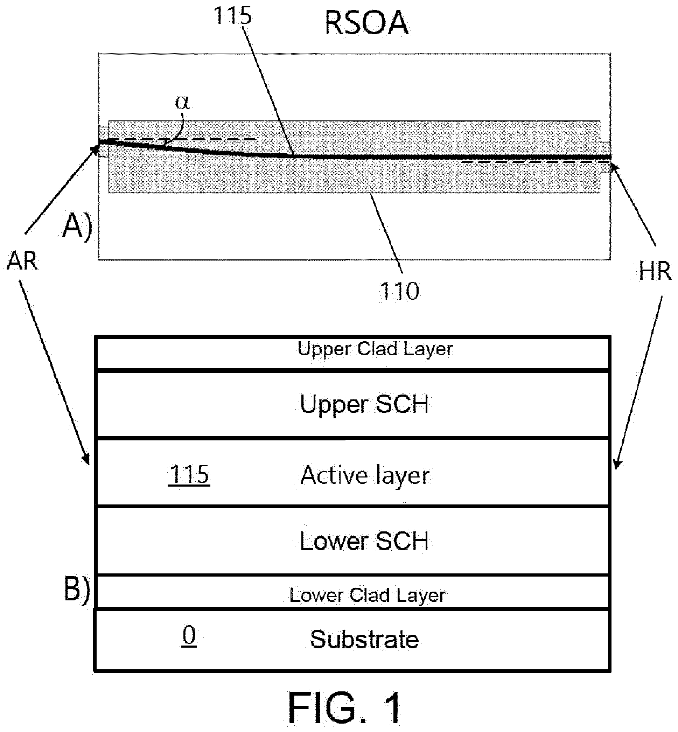

In an aspect, the present disclosure provides a gain medium of a reflective semiconductor optical amplifier (RSOA) and/or a semiconductor optical amplifier (SOA) for tunable laser application with high-power operability at elevated temperature. Figure 1 is a schematic diagram of a RSOA with a gain medium in both top and side views according to an embodiment of the present invention. This diagram is merely an example, which should not unduly limit the scope of the claims. One of ordinary skill in the art would recognize many variations, alternatives, and modifications. As shown in part A), a top view of the gain medium 110 of the RSOA reveals a linear active region 115 laid in an optical cavity between a front facet with anti-reflective (AR) coating and a back facet with high-reflective (HR) coating.

When the gain medium 110 is driven by a bias current a carrier-stimulated emission in the active region 115 is generated between the front facet and the back facet before lasing out the front facet. The stimulated light emission is transmitted along with the active region 115 which acts as a light waveguide. Specifically in this top view diagram, the linear active region 115 appears like a linear waveguide which forms an angled ($\alpha$) intersection with the front facet with AR coating so that the stimulated light emission mostly is not reflected to itself. While, the linear active region 115 is substantially perpendicular to the back facet with HR coating allowing a substantially total reflection of the stimulated light emission from the back facet. Eventually, the stimulated light emission generated in the active region 115 exits the front facet through the AR coating.

In part B) of Figure 1, it is a cross-section side view of the main medium 110 revealing a multi-layer structure with the active region 115 appeared as an active layer in a central portion of the multi-layer structure. The active layer 115 is sandwiched between an upper separated confinement heterostructure (SCH) in p-type at upper portion thereof and a lower SCH in n-type at lower portion. The upper SCH in p-type and lower SCH in n-type together with the active layer 115 form a semiconductor diode, which is capped by an upper clad layer for a p-type electrode (not shown) and a lower clad layer for a n-type electrode (not shown) beneath. Note, the terms of upper or lower merely are referred to the figure illustration and do not limit actual device in just one setting in orientation. Optionally, for the convenience of manufacture of these heterostructures on a wafer substrate, the n-type electrode of the lower clad layer can be formed first on the substrate 0, followed by other layers of the gain medium 110 shown in the part B of the Figure 1. Optionally, the active layer 115 is a multi-quantum-well structure. Depending on working wavelength spectrum, different semiconductor materials including one or more compound semiconductors or a combination of InAsP, GaInNAs, GaInAsP, GaInAs, and AlGaInAs may be employed for forming the multi-layers in the active layer with multi-quantum-well structure. Optionally, the each of the multi-layers in the active layer can be doped, e.g., n-type electronic impurity, to enhance performance for light amplification. Optionally, the semiconductor diode around the active layer 115 is configured as a laser diode with the optical cavity between the front facet and the back facet for the gain medium to become a laser source of a RSOA. Optionally, the RSOA is used for a wide-band tunable laser application.

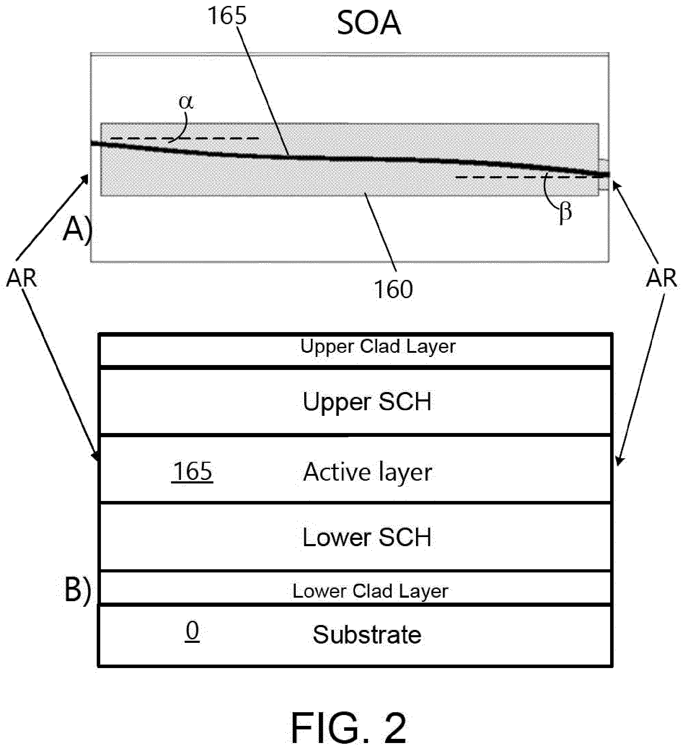

Figure 2 is a schematic diagram of a SOA with a gain medium in both top and side views according to an embodiment of the present invention. This diagram is merely an example, which should not unduly limit the scope of the claims. One of ordinary skill in the art would recognize many variations, alternatives, and modifications. In an embodiment, the gain medium for SOA can be substantially same as the gain medium for RSOA described above in Figure 1. Similarly, in Part A), a top view of the gain medium 160 of the SOA reveals a linear active region 165 laid in a cavity between a back facet and a front facet both with anti-reflective (AR) coating. Specifically, the linear active region 165 forms an angled ($\alpha$) intersection with the back facet and angled ($\beta$) intersection with the front facet so that the light can enter the active region 165 of the gain medium 160 from the back facet with minimum reflection, being amplified by the active region 165, and exit from the front facet without reflection.

In part B) of Figure 2, a cross-section side view of the main medium 160 reveals a multi-layer structure with the active region 165 is also shown as an active layer in a central portion of the multi-layer structure, substantially the same as that shown in part B) of Figure 1. The active layer 165 is sandwiched between a P-type upper SCH at upper portion and a N-type SCH at lower portion which forms a semiconductor diode with a p-type electrode (not shown) on an upper clad layer at the upper portion and a n-type electrode (not shown) beneath a lower clad layer at the lower portion. Note, the terms of upper or lower merely are referred to the figure illustration and do not limit actual device in just one setting in orientation. Optionally, the active layer 165 is a multi-quantum-well structure. Depending on working wavelength spectrum, different semiconductor materials including one or more compound semiconductors or a combination of InAsP, GaInNAs, GaInAsP, GaInAs, and AlGaInAs may be employed for forming the multi-layers in the active layer with multi-quantum-well structure. Optionally, the each of the multi-layers in the active layer can be doped, e.g., n-type electronic impurity, to enhance performance for light amplification. Optionally, the P-type SCH includes multi-layer optical confinement structure doped in p-type impurity. Optionally, the N-type SCH includes a n-type multi-layer optical confinement structure. Optionally, the semiconductor diode formed by the active layer 165 sandwiched by the p-type SCH and the n-type SCH is configured as a laser diode with the optical cavity between the back facet with AR coating and the front facet with AR coating, which is used for a SOA.

In a specific embodiment, the gain medium with the active layer in multi-quantum-well structure for both the RSOA and SOA is configured to yield high saturation output power for high-power tunable laser operated at elevated temperature. In theory, the saturation output power $P_{sat}$ of a gain medium with the active layer as shown in Figure 1 and Figure 2 can be expressed as following:

$$P_{sat}^c = \left(\frac{dw}{\Gamma}\right)\left(h\nu\frac{1}{a}\frac{1}{\tau_s}\right).$$

(1)

In the expression (1), $d$ is a thickness of the active layer of the gain medium, w is a width of the active layer, $\Gamma$ is optical confinement factor, $\alpha$ is a differential gain, and $\tau_s$ is carrier lifetime. In order to enhance the saturation output power $P_{sat}$, conventional approaches included increasing the width w of the active layer or reducing optical confinement factor $\Gamma$ (or increasing ratio of $d/\Gamma$). Downside of reduced confinement factor or increased width of the active layer is the gain of the gain medium is also reduced. In order to obtain higher gain for the (SOA/RSOA) device, longer cavity length and higher operating current are normally required to achieve higher saturation output power. But high operating current mostly is not recommended for devices in elevated temperature operation.

In this disclosure, an improved gain medium used for SOA (or RSOA) with high saturation power $P_{sat}$ with reasonably high gain is provided with an active layer in modulated n-type doping and an optimized optical confinement factor $\Gamma$ to reduce carrier lifetime $\tau_s$ and differential gain $\alpha$. This makes it a very suitable gain medium for the SOA or RSOA in high-power tunable laser application.

In the embodiment, the gain medium is a multilayer heterostructure including an active layer configured as a multi-quantum-well structure. Optionally, the active layer includes modulated doping with n-type electronic impurity. Optionally, the active layer is undoped. The multi-quantum-well structure of the active layer is provided as a hetero-junction structure including multiple well layers separated by respective barrier layers. In the embodiment, specific material choices for these well layers and barrier layers, and physical parameters like thickness and doping characteristics are designed to yield different bandgaps and oscillation characteristics for the stimulated light emission within multi-well structure of the active layer in order to provide a certain light spectrum range that is fit, for example, for the applications of the RSOA or SOA for tunable laser operating in wide-band (C-band or O-band) wavelengths.

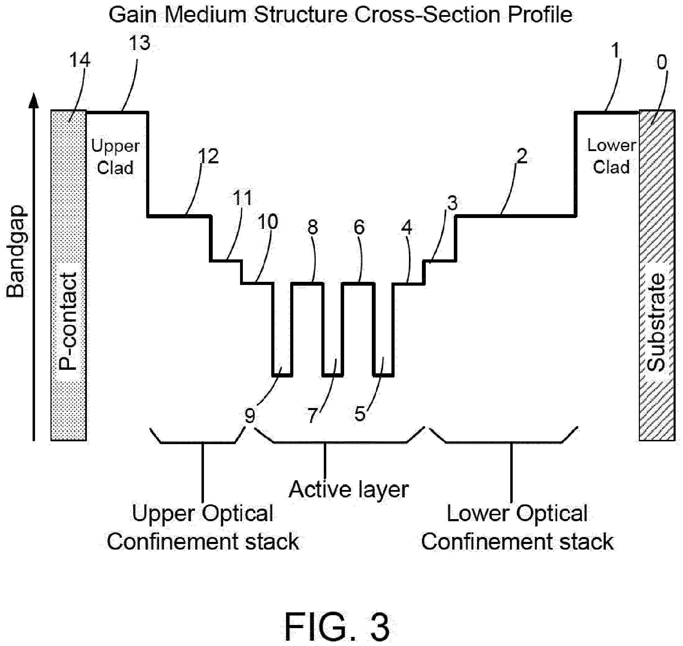

Figure 3 is a simplified bandgap diagram of a gain medium of RSOA/SOA for tunable laser application according to an embodiment of the present invention. This diagram is merely an example, which should not unduly limit the scope of the claims. One of ordinary skill in the art would recognize many variations, alternatives, and modifications. As shown, a gain medium structure cross-section profile is illustrated by a physical stack of multilayers including upper clad, upper optical confinement stack, active layer, lower optical confinement stack, and lower clad formed in series on a substrate 0 up to a p-type contact layer 14. A first layer formed on the substrate 0 is a lower clad laser 1 followed by a lower optical confinement stack including layer 2 and layer 3, which forms the lower separated confinement heterostructure (lower SCH) shown in Figure 1 and Figure 2. Further, a multi-quantum-well structure including multiple well layers 5, 7, 9 separated by respective barrier layers 4, 6, 8, and 10 is formed between the lower optical confinement stack and the upper optical confinement stack, which forms the active layer 115 of Figure 1 or the active layer 165 of Figure 3. Additionally, the upper optical confinement stack includes layers 11 and 12 formed on the active layer, which forms the upper separated confinement heterostructure (upper SCH) shown in Figure 1 and Figure 2. Lastly, an upper clad layer 13 is formed on which the p-type contact layer 14 can be added.

Referring to Figure 3, the active layer is located between an upper optical confinement stack and a lower optical confinement stack. Optionally, the active layer includes several well layers and barrier layers made by different semiconductor materials including one or more compound semiconductors or a combination of InAsP, GaInNAs, GaInAsP, GaInAs, and AlGaInAs. In a specific embodiment, the well layers 5, 7, 9 of the active layer are provided by compound semiconductor materials based on $Ga_xIn_{1-x}As_yP_{1-y}$ each with a narrow thickness of 5 +/-1 nm. By tunning x, y in composition in the well layer, a compressive strain level (e.g., about 0.8% to 1.2%) and photoluminescence wavelength about 1570 +/-5 nm can be achieved for determining band width of the SOA or RSOA for tunable laser. In the embodiment, the barrier layers 4, 6, 8, and 10 of the active layer are also $Ga_xIn_{1-x}As_yP_{1-y}$-based material. Each barrier layer has a thickness of 10 +/-2 nm and a barrier height of 1.25 +/-0.05 $\mu$m. By tunning x, y in composition in the barrier layer, a tensile strain level (e.g., about -0.1% to -0.5%) and photoluminescence wavelength about 1200-1300 nm can be achieved to allow carrier distribution more uniformly in the active layer and have shorter carrier lifetime. Referring to Figure 3, the cross-section profile is also shown as a bandgap profile, the well layers are associated with the smallest bandgap corresponding to the smaller photoluminescence wavelength value. The barrier layers are associated with relatively larger bandgap corresponding to the longer wavelength value of photoluminescence.

Optionally, the active layer is undoped. Optionally, the active layer, particularly, the well layers and barrier layers are modulated doped with n-type electronic impurity at about 1e18 $cm^{-3}$ to 3e18 $cm^{-3}$ to reduce carrier lifetime $\tau_s$ and differential gain $\alpha$ for enhancing saturation output power of the light emission generated therein. Additionally, the design with a narrower quantum well in the active layer is to have a lower confinement factor $\Gamma$ so that the saturation output power can be reduced (see expression (1)). More quantum well layers may add total active layer thickness d, reducing a confinement factor ratio $\Gamma/d$ to enhance output power. Optionally, the number of the well layer can be more than three. Two large thickness may cause the confinement factor reduced. The confinement factor ratio $\Gamma/d$ needs to be adequate for the gain medium being applied for ROSA or SOA. If it is too small, the gain becomes low in SOA and threshold current becomes high for RSOA. If it is too large, the saturation power would be low. The adequate value of the confinement factor ratio $\Gamma/d$ is depended on cavity length used in an application. For an application with 1 mm cavity length for either a RSOA or SOA device, an optimized value for confinement factor ratio of $\Gamma/d$ is 1.27+/-0.15 (1/$\mu$m). Accordingly, an optimized gain parameter Go of the device can be 15+/-5 cm$^{-1}$.

In a specific embodiment, the lower optical confinement stack, including layers 2 and 3, is made by InGaAsP-based material. Layer 2 is designed with a thickness of about 50+/-10 nm and layer 3 with a thickness of about 10+/-2 nm. Referring to Figure 3, physical parameters (material composition, thickness, and doping level) of the lower optical confinement stack can be tuned to give higher and higher bandgaps stepwise above the active layer. The bandgap of layer 3 is higher than the barrier layer 4 and the bandgap of layer 2 is further higher than the layer 3. Optionally, the lower optical confinement stack is undoped. Optionally, the lower optical confinement stack is doped with n-type impurity to form a n-side separated confinement heterostructure next to a n-type lower clad layer. The design of the n-side separated confinement heterostructure is to have more mode in the n side so that the free carrier absorption can be reduced to effectively confine the light excitation within the active layer from the lower portion of the gain medium. Similarly, the upper optical confinement stack, including layers 11 and 12, is made by InGaAsP-based material. Layer 11 is designed with a thickness of 10+/-2 nm similar to the barrier layer 10 but with larger bandgap or shorter photoluminescence wavelength (~1200nm). Layer 12 is designed with a larger thickness of about 20+/-5 nm with even larger bandgap or shorter photoluminescence wavelength (~1100nm), providing photo confinement effect on the upper portion of the gain medium.

Beneath the layer 2 is the lower clad layer 1 which is made by InP-based material with a thickness of about 1000 nm formed on the substrate 0 which is optionally also an InP-wafer with n-type doping level > 1e18 cm$^{-3}$. Optionally, the lower clad layer 1 is doped to n-type at a level of about 1e18 cm$^{-3}$. Optionally, a n-metal may be formed beneath the lower clad layer 1 on the substrate 0 or formed beneath the substrate 0 to form an electrode contact. Above the layer 12 is the upper clad layer 13 which is made also by InP-based material with a thickness of about 2300nm. The upper clad layer 13 is doped with p-type impurity at a level of 1e18 cm$^{-3}$. Optionally, an upper electric contact layer 14 based on InGaAs is formed on the upper clad layer 13. Optionally, the upper electric contact layer 14 is designed with a thickness of about 300 nm and with p-type doping level > 1e19 cm$^{-3}$.

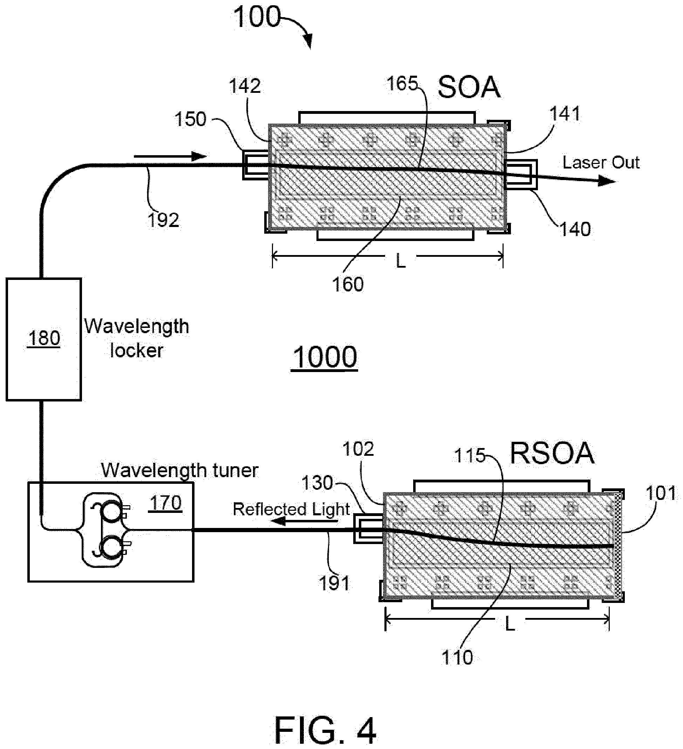

In another aspect of the present disclosure, the gain medium described hereabove is configured to form a reflective semiconductor optical amplifier (RSOA) with an AR front facet and a HR back facet or a semiconductor optical amplifier with AR coating on both front facet and back facet for a tunable laser application. Figure 4 is a schematic diagram of a tunable laser based on a reflective semiconductor optical amplifier (RSOA) combined with a semiconductor optical amplifier (SOA) according to an embodiment of the present invention. This diagram is merely an example, which should not unduly limit the scope of the claims. One of ordinary skill in the art would recognize many variations, alternatives, and modifications. As shown, the tunable laser module 100 includes a RSOA with a first gain medium 110 on a silicon photonics substrate 1000 to generate a stimulated emission, a wavelength tuner 170 formed in the silicon photonics substrate 10 and coupled to the RSOA to receive a reflected light in a wide band tuned based on the stimulated emission, a wavelength locker 180 formed in the silicon photonics substrate 1000 and coupled to the wavelength tuner 170 to lock wavelengths of the light, and a SOA with a second gain medium 160 in an output path coupled to the wavelength locker to pass the light with a single amplification in power.

Optionally, the first gain medium 110 of RSOA is a flip chip bonded on the silicon photonics substrate 1000. The chip includes an active region 115 capped by optical confinement heterostructure in a clad region configured as a waveguide throughout an optical cavity length L from a back facet 101 to a front facet 102, within which a stimulated emission or laser light is generated. The front facet 102 is characterized by a first reflectance Rf and the back facet 101 is characterized by a second reflectance Rb. Optionally, the first reflectance Rf is very low in value, e.g., 0.005%, provided by an anti-reflective coating on the front facet 102. Optionally, the second reflectance Rb is very high in value, e.g., >90%, provided by a high-reflective coating on the back facet 101. Optionally, the active region 115 in waveguide form is configured to be in a curved shape with a non-perpendicular angle $\alpha$ relative to the front facet 102 (as seen in Figure 1) to reduce direct back reflection of the light thereby but with a substantially perpendicular angle relative to back facet 101 to maximize the reflection. The laser light is reflected by the back facet 101 and emitted out through the front facet 102 into a first waveguide 191 via a coupler 130. Through the first waveguide 191 the laser light is delivered to the wavelength tuner 170. In an embodiment for the tunable laser in high-power operation, the first gain medium 110 of RSOA is configured in a laser-diode chip to yield a high saturation power $P_{sat}$ at elevated temperature by design. The high saturation power means that the RSOA is configured to produce a high stable laser power. Yet, the higher saturation power can be achieved by using a low driving current with a shorter cavity to keep the gain high enough in order for it to operate at elevated temperature of ~50 °C with a saturation power higher than 15dBm.

Referring to Figure 4, the laser light, after passing through the wavelength tuner 170 and wavelength locker 180, with its wavelength locked in a specific value in a wide-band spectrum (such as C-band), is inputted via an input coupler 150 in the SOA where it is further amplified in power before being outputted via an output coupler 140. Optionally, the second gain medium 160 of SOA is another flip chip bonded on the silicon photonics substrate 1000. The gain medium 160 includes a gain region 165 capped in a clad region configured as a waveguide extended in a length L through an amplifying cavity from a back facet 142 coupled to the input coupler 150 and a front facet 141 coupled to the output coupler 140. In the embodiment, the front facet 141 is characterized by a first reflectance Rf and the back facet 142 is characterized by a second reflectance Rb. Optionally, both the back facet 142 and the front facet 141 are coated by anti-reflective coating to give a very low value, e.g., 0.005%, of the first reflectance Rf and the second reflectance Rb for forming a symmetric semiconductor optical amplifier to allow the light to pass through once and be amplified in power. Optionally, the active region 165 in waveguide form is configured to be in a curved shape with a non-perpendicular angle relative to either the back facet 142 or the front facet 141 to reduce direct back reflection of the light thereby. This light received via the back facet 142 from the input coupler 150 is simply passed through the length L of the cavity and amplified therein before outputting via the front facet 141.

In an embodiment of RSOA/SOA for tunable laser in high-power operation, the first gain medium 110 of RSOA is configured as a laser-diode chip to yield a high saturation power $P_{sat}$ at elevated temperature by design. The high saturation power means that the RSOA is configured to produce a high stable laser power. Yet, the higher saturation power can be achieved by using a low driving current with a short (~1mm) cavity to keep the gain high enough in order for it to operate at elevated temperature of -50 °C with a saturation power higher than 15dBm. In the embodiment, the second gain medium 160 of SOA can be also configured in a chip to yield a high saturation output power $P_{sat}$ >15dBm by design, meaning to have a high amplified maximum output power at elevated temperature of about 50 °C.

In the embodiment, a modulated n-doped active layer stack is provided with a narrow (5+/-2nm) well multi-quantum-well structure in the gain medium for making chips for RSOA or SOA with smaller confinement factor and reduced carrier lifetime without increasing differential gain to achieve higher saturation power [see expression (1)]. The barrier GaInAsP material in the active layer also is tuned to produce photoluminescence at 1200nm~1300nm to allow carrier distribution more uniformly in the active layer and have shorter carrier lifetime. At the same time, the gain parameter of the gain medium containing the modulated n-doped active layer stack is kept high enough at about 15+/-5 cm$^{-1}$ to have the RSOA or SOA device to operate at lower injected current with a small (~1mm) cavity length. The optimized active layer confinement factor ($\Gamma$/d) is limited in 1.27+/-0.15 (1/$\mu$m) so that the device can be operated at elevated temperature of 50 °C or higher.

While the above is a full description of the specific embodiments, various modifications, alternative constructions and equivalents may be used. Therefore, the above description and illustrations should not be taken as limiting the scope of the present invention which is defined by the appended claims.

The following is a list of further preferred embodiments of the invention:

Embodiment 1: An optical amplifier comprising:

an active layer configured to generate an electromagnetic emission;

a first optical confinement layer disposed on a first side of the active layer; and
a second optical confinement layer disposed on a second side of the active layer, the second optical confinement layer having a thickness different from the first optical confinement layer, and the respective different thicknesses of the first and second optical confinement layers being configured to decrease an optical confinement factor and to increase a saturation output power of the active layer.

Embodiment 2: The optical amplifier of embodiment 1 wherein the active layer and the first and second optical confinement layers are formed of different semiconductor materials.

Embodiment 3: The optical amplifier of embodiment 2 wherein the active layer comprises $Ga_xIn_{1-x}As_yP_{1-y}$ and wherein the first and second optical confinement layers comprise $Ga_xIn_{1-x}As_yP_{1-y}$ with values of x and y for the first and second optical confinement layers being different than the respective values for the active layer.

Embodiment 4: The optical amplifier of embodiment 1 wherein the first optical confinement layer having a first thickness is doped with a first type of doping and wherein the second optical confinement layer having a second thickness is doped with a second type of doping.

Embodiment 5: The optical amplifier of embodiment 1 wherein the first optical confinement layer is doped with n-type doping and is thicker than the second optical confinement layer doped with p-type doping.

Embodiment 6: The optical amplifier of embodiment 1 wherein the active layer comprises a plurality of well layers separated by barrier layers, wherein each of the well and barrier layers comprises a plurality of semiconductor materials, and wherein the well layers are of different thickness than the barrier layers.

Embodiment 7: The optical amplifier of embodiment 6 wherein the semiconductor materials are based on $Ga_xIn_{1-x}As_yP_{1-y}$.

Embodiment 8: The optical amplifier of embodiment 6 wherein the well layers are thinner than the barrier layers.

Embodiment 9: The optical amplifier of embodiment 6 wherein the well layers have a smaller bandgap relative to the barrier layers.

Embodiment 10: The optical amplifier of embodiment 6 wherein each layer of the well layers is doped with an n-type material.

Embodiment 11: The optical amplifier of embodiment 6 wherein each layer of the barrier layers is doped with an n-type material.

Embodiment 12: The optical amplifier of embodiment 1 wherein the first and second optical confinement layers comprises multiple layers made from a semiconductor material based on $Ga_xIn_{1-x}As_yP_{1-y}$.

Embodiment 13: The optical amplifier of embodiment 12 wherein each layer of the multiple layers in the first and second optical confinement layers has a different thickness.

Embodiment 14: The optical amplifier of embodiment 12 wherein each of the multiple layers in the first and second optical confinement layers exhibits a different bandgap.

Embodiment 15: The optical amplifier of embodiment 12 wherein each of the multiple layers in the first and second optical confinement layers exhibits a higher bandgap than the active layer.

Embodiment 16: The optical amplifier of embodiment 12 wherein a bandgap of each successive layer of the multiple layers in the first and second optical confinement layers increases with a distance of the each successive layer relative to the active layer.

Embodiment 17: The optical amplifier of embodiment 1 further comprising first and second clad layers made of a different semiconductor material than the active layer and the first and second optical confinement layers, wherein the first and second clad layers are disposed adjacent to the first and second optical confinement layers, respectively.

Embodiment 18: The optical amplifier of embodiment 17 wherein:

the active layer comprises $Ga_xIn_{1-x}As_yP_{1-y}$;
the first and second optical confinement layers comprise $Ga_xIn_{1-x}As_yP_{1-y}$ with values of x and y for the first and second optical confinement layers being different than the respective values for the active layer; and

the first and second clad layers comprise InP.

Embodiment 19: The optical amplifier of embodiment 17 wherein the first clad layer has a first thickness and a first type of doping and wherein the second clad layer has a second thickness and a second type of doping.

Embodiment 20: The optical amplifier of embodiment 17 wherein the first clad layer is doped with n-type doping and is thinner than the second clad layer doped with p-type doping.

## Claims

1. An optical amplifier comprising:

an active layer configured to generate an electromagnetic emission;

a first optical confinement layer disposed on a first side of the active layer; and

a second optical confinement layer disposed on a second side of the active layer, the second optical confinement layer having a thickness different from the first optical confinement layer, and the respective different thicknesses of the first and second optical confinement layers being configured to decrease an optical confinement factor and to increase a saturation output power of the active layer.

2. The optical amplifier of claim 1 wherein the active layer and the first and second optical confinement layers are formed of different semiconductor materials.

3. The optical amplifier of claim 2 wherein the active layer comprises $Ga_xIn_{1-x}As_yP_{1-y}$ and wherein the first and second optical confinement layers comprise $Ga_xIn_{1-x}As_yP_{1-y}$ with values of x and y for the first and second optical confinement layers being different than the respective values for the active layer.

4. The optical amplifier of one of claims 1 to 3 wherein the first optical confinement layer having a first thickness is doped with a first type of doping and wherein the second optical confinement layer having a second thickness is doped with a second type of doping.

5. The optical amplifier of one of claims 1 to 4 wherein the first optical confinement layer is doped with n-type doping and is thicker than the second optical confinement layer doped with p-type doping.

6. The optical amplifier of one of claims 1 to 5 wherein the active layer comprises a plurality of well layers separated by barrier layers, wherein each of the well and barrier layers comprises a plurality of semiconductor materials, and wherein the well layers are of different thickness than the barrier layers.

7. The optical amplifier of claim 6 wherein the semiconductor materials are based on $Ga_xIn_{1-x}As_yP_{1-y}$.

8. The optical amplifier of claim 6 wherein the well layers are thinner than the barrier layers.

9. The optical amplifier of claim 6 wherein the well layers have a smaller bandgap relative to the barrier layers.

10. The optical amplifier of claim 6 wherein each layer of the well layers is doped with an n-type material; or wherein each layer of the barrier layers is doped with an n-type material.

11. The optical amplifier of one of claims 1 to 10 wherein the first and second optical confinement layers comprises multiple layers made from a semiconductor material based on $Ga_xIn_{1-x}As_yP_{1-y}$.

12. The optical amplifier of claim 11 wherein each layer of the multiple layers in the first and second optical confinement layers has a different thickness; or

wherein each of the multiple layers in the first and second optical confinement layers exhibits a different bandgap; or

wherein each of the multiple layers in the first and second optical confinement layers exhibits a higher bandgap than the active layer; or

wherein a bandgap of each successive layer of the multiple layers in the first and second optical confinement layers increases with a distance of the each successive layer relative to the active layer.

13. The optical amplifier of one of claims 1 to 12 further comprising first and second clad layers made of a different semiconductor material than the active layer and the first and second optical confinement layers, wherein the first and second clad layers are disposed adjacent to the first and second optical confinement layers, respectively.

14. The optical amplifier of claim 13 wherein:

the active layer comprises $Ga_xIn_{1-x}As_yP_{1-y}$;

the first and second optical confinement layers comprise $Ga_xIn_{1-x}As_yP_{1-y}$ with values of x and y for the first and second optical confinement layers being different than the respective values for the active layer; and

the first and second clad layers comprise InP.

15. The optical amplifier of claim 14 wherein the first clad layer has a first thickness and a first type of doping and wherein the second clad layer has a second thickness and a second type of doping; or

wherein the first clad layer is doped with n-type doping and is thinner than the second clad layer doped with p-type doping.

RSOA

115

α

A)

110

AR

HR

B)

| Upper Clad Layer |
| Upper SCH |
| 115    Active layer |
| Lower SCH |
| Lower Clad Layer |
| 0    Substrate |

# FIG. 1

FIG. 2

Gain Medium Structure Cross-Section Profile

FIG. 3

FIG. 4

Europäisches
Patentamt

European
Patent Office

Office européen
des brevets

# EUROPEAN SEARCH REPORT

Application Number

EP 21 21 4401

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/080484 A1 (SHIGIHARA KIMIO [JP]) 26 March 2009 (2009-03-26) | 1-5, 11-15 | INV. H01S5/20 |
| Y | * paragraphs [0004] - [0011], [0037] - [0050], [0078] - [0115], [0212] - [0241]; figures 1,2,6-9,17,19,21 * | 6-12 | H01S5/14 H01S5/32 H01S5/50 |
| X | JP 2007 220692 A (NEC CORP) 30 August 2007 (2007-08-30) | 1,3-5, 13-15 | ADD. H01S5/02 |
| Y | * paragraphs [0002] - [0010], [0023] - [0052]; figures 1-10 * | 6-12 | H01S5/028 H01S5/10 H01S5/30 |
| X | US 2020/136353 A1 (RYVKIN BORIS [RU] ET AL) 30 April 2020 (2020-04-30) | 1,2,4,5, 13-15 | H01S5/34 H01S5/343 |
| Y | * paragraphs [0017] - [0047]; figures 1-6 * | 6-12 | |
| Y | SHIMIZU H ET AL: "Low threshold 1.3 um InAsP n-type modulation doped MQW lasers grown by gas-source molecular-beam epitaxy", ELECTRONICS LETTERS, THE INSTITUTION OF ENGINEERING AND TECHNOLOGY, GB, vol. 34, no. 9, 30 April 1998 (1998-04-30) , pages 888-889, XP006009696, ISSN: 0013-5194, DOI: 10.1049/EL:19980662 * page 888, left-hand column, paragraph 1 - page 889, left-hand column, paragraph 1; figures 1-4 * | 6-10 | |

TECHNICAL FIELDS SEARCHED (IPC)

H01S

The present search report has been drawn up for all claims

| Place of search | Date of completion of the search | Examiner |
|---|---|---|
| Munich | 3 May 2022 | Laenen, Robert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 4401

This annex lists the patent family members relating to the patent documents cited in the above-mentioned European search report.
The members are as contained in the European Patent Office EDP file on
The European Patent Office is in no way liable for these particulars which are merely given for the purpose of information.

03-05-2022

| Patent document cited in search report | | Publication date | Patent family member(s) | | Publication date |
|---|---|---|---|---|---|
| US 2009080484 | A1 | 26-03-2009 | JP | 5002391 B2 | 15-08-2012 |
| | | | JP | 2009081249 A | 16-04-2009 |
| | | | US | 2009080484 A1 | 26-03-2009 |
| JP 2007220692 | A | 30-08-2007 | JP | 2007220692 A | 30-08-2007 |
| | | | WO | 2005074081 A1 | 11-08-2005 |
| US 2020136353 | A1 | 30-04-2020 | CN | 111108657 A | 05-05-2020 |
| | | | EP | 3646420 A1 | 06-05-2020 |
| | | | US | 2020136353 A1 | 30-04-2020 |
| | | | WO | 2019002694 A1 | 03-01-2019 |

EPO FORM P0459

For more details about this annex : see Official Journal of the European Patent Office, No. 12/82